(19) Europäisches Patentamt

European Patent Office

Office européen des brevets

(11) **EP 1 273 106 B1**

(12) **EUROPÄISCHE PATENTSCHRIFT**

| | |
|---|---|
| (45) Veröffentlichungstag und Bekanntmachung des Hinweises auf die Patenterteilung:<br>**21.12.2005 Patentblatt 2005/51** | (51) Int Cl.⁷: **H04B 7/005** |
| (21) Anmeldenummer: **01919158.4** | (86) Internationale Anmeldenummer:<br>**PCT/DE2001/000791** |
| (22) Anmeldetag: **02.03.2001** | (87) Internationale Veröffentlichungsnummer:<br>**WO 2001/065722 (07.09.2001 Gazette 2001/36)** |

(54) **VERFAHREN UND SENDESCHALTUNG ZUR ERZEUGUNG EINES SENDESIGNALS**

METHOD AND TRANSMISSION CIRCUIT FOR PRODUCING A TRANSMISSION SIGNAL

PROCEDE ET CIRCUIT D'EMISSION DESTINES A PRODUIRE UN SIGNAL D'EMISSION

| | |
|---|---|
| (84) Benannte Vertragsstaaten:<br>**DE FR GB** | (73) Patentinhaber: **SIEMENS AKTIENGESELLSCHAFT**<br>**80333 München (DE)** |
| (30) Priorität: **03.03.2000 DE 10010635** | (72) Erfinder: **WILHELM, Hartmut**<br>**81477 Muenchen (DE)** |
| (43) Veröffentlichungstag der Anmeldung:<br>**08.01.2003 Patentblatt 2003/02** | (56) Entgegenhaltungen:<br>**WO-A-99/66637**    **US-A- 5 805 640** |

**Beschreibung**

Die Erfindung betrifft ein Verfahren zur Erzeugung eines amplituden- und winkelmodulierten Sendesignals.

In derzeit üblichen Mobilfunksystemen werden die zu übertragenden Informationen zunächst geeignet kodiert und in sogenannte Symbolfolgen umgesetzt. Bei der "I/Q-Modulation" wird dann die jeweilige Symbolfolge in ein Basisbandsignal mit einer Inphase-Komponente, kurz I genannt, und einer dazu senkrechten Quadraturkomponente, kurz Q genannt, umgewandelt. Die I- und die Q-Komponente spannen hierbei mathematisch gesehen eine komplexe Ebene auf, in der sich ein Signal zu jedem Zeitpunkt durch einen vektor, den sogenannten "Zeiger", repräsentieren lässt. Ein bestimmter Signalabschnitt bzw. Signalverlauf lässt sich folglich durch den Verlauf und die Geschwindigkeit der Bahn des Zeigers in dieser komplexen Ebene, den sogenannten Sendekurvenzug, beschreiben. Üblicherweise werden die I- und Q-Komponente des auszusendenden Signals in einer nachfolgenden Schaltung in das amplituden- und winkelmodulierte Sendesignal umgesetzt.

Anstatt in den kartesischen Koordinaten I und Q der komplexen Ebene lässt sich der Zeiger auch in Polarkoordinaten beschreiben, wobei zu einem bestimmten Zeitpunkt die Länge des Zeigers die Amplitude angibt und der Winkel des Zeigers den aktuellen Winkel des Sendesignals angibt. Der I- und/oder Q-Wert enthalten folglich indirekt die Informationen über die aktuelle Amplitude und den aktuellen Winkel des auszusendenden Signals. Der Begriff "Winkel" steht hierbei stellvertretend für die Größen "Phase" oder "Momentanfrequenz" (d.h. die zeitliche Ableitung der Phase), genau wie "Winkelmodulation" ein Oberbegriff für Phasen- und Frequenzmodulation ist.

Es würde sich daher anbieten, anstelle der kartesischen Koordinaten des Zeigers, d.h. der I- und der Q-Komponente, direkt die polaren Komponenten, die Amplitude und den Winkel zu verwenden, um daraus das analoge amplituden- und winkelmodulierte Sendesignal zu erzeugen.

Die Ausgabe der polaren Komponenten des Basisband-Signals anstelle der I- und Q-Komponenten hat den Vorteil, dass nicht erst die I- und Q-Komponenten in komplizierteren Schaltungen in ein amplituden- und winkelmoduliertes Signal umgewandelt werden müssen, sondern dass die Winkelinformation und die Amplitudeninformation auf einfache Weise direkt in ein analoges Signal gewandelt werden können.

Ganz besondere Vorteile hat dies bei einem Verfahren zur Verstärkung des Sendesignals, bei dem das winkel- und amplitudenmodulierte Sendesignal zunächst in einen amplitudenmodulierten Anteil und einen winkelmodulierten Anteil aufgespalten wird und das winkelmodulierte Signal dann auf einen Signaleingang des Sendeverstärkers gegeben wird und das amplitudenmodulierte Signal beispielsweise auf den Versorgungsspannungseingang des gleichen Sendeverstärkers gegeben wird. Dort wird das gesamte Signal wieder zusammengesetzt. Dieses Verfahren hat den Vorteil, dass am Signaleingang des Sendeverstärkers das winkelmodulierte Signal mit konstanter Amplitude vorliegt und daher der Verstärker bezüglich dieser Amplitude optimiert in Sättigung betrieben werden kann. Es ist auf diese Weise eine effizientere, lineare Verstärkung möglich, als wenn direkt das amplituden- und phasenmodulierte Signal auf den Signaleingang gegeben und in üblicher Weise verstärkt wird. Dieses Verfahren wird allgemein "Envelope Elimination and Restoration" (EER) genannt, da zunächst vom Signal die durch die Amplitude gegebene "Hüllkurve" vom winkelmodulierten Signal entfernt und dann wieder hinzugefügt wird. Bei einer Verwendung der polaren Komponenten des durch den Zeiger in der I/Q-Ebene repräsentierten Signals lassen sich das winkelmodulierte Signal und das amplitudenmodulierte Signal getrennt erzeugen und verstärken und dann schließlich am Sendeverstärker wie bei dem vorgenannten EER-Verfahren zusammenfügen. Der komplette Verfahrensschritt einer Umwandlung der I- und Q-Komponenten in ein winkelmoduliertes Signal und eine Amplitudeninformation kann dann entfallen.

Bei vielen Empfängern werden die zu übermittelnden Informationen nicht unterschiedslos aus dem kompletten Verlauf der Bahn des Zeigers in der I/Q-Ebene zurückgewonnen, sondern es sind in den Übertragungs-Standards bestimmte Punkte innerhalb der I/Q-Ebene festgelegt, und die eigentliche Information im Signal lässt sich daraus ermitteln, welche dieser Punkte in welcher Reihenfolge vom Signal bzw. vom zugehörigen Zeiger in der I/Q-Ebene "angefahren" werden. Häufig liegen diese festgelegten Punkte in zueinander festen Abständen auf einem genau definierten Kreisumfang um den Ursprung der I/Q-Ebene. Dies ist beispielsweise beim 3π/8-8PSK-Modulationsverfahren, wie es im EDGE-Übertragungsstandard verwendet wird, oder beim n/4-DQPSK-Verfahren der Fall. Da sich diese Punkte alle auf einem Kreis um den Ursprung befinden, bedeutet dies, dass die Punkte im Prinzip auch durch eine reine Veränderung des Winkels angefahren werden können, indem der Zeiger mit seiner Spitze einfach die besagte Kreisbahn entlang fährt. In diesem Fall würde der Zeiger immer seine konstante Länge behalten, d.h. die Amplitude des Signals würde sich nicht ändern. Es könnte ein rein winkelmoduliertes Signal verwendet werden. Eine reine Winkelmodulation ist aber insofern ungünstig, als die für die Übertragung benötigte Bandbreite unnötig hoch wäre. Zur Übertragung mit niedrigem Bandbreitenbedarf werden daher schmalbandige Impulse zeitlich derart überlagert, dass der Zeiger nacheinander an den gewünschten Punkten in der I/Q-Ebene vorbeiläuft. Hierbei ändert sich im Allgemeinen nicht nur der Winkel des Zeigers, sondern auch die Amplitude, d.h. es ist ein winkel- und amplitudenmoduliertes Signal notwendig.

Bei den meisten höherstufigen linearen Modulationsverfahren, wie beispielsweise der sogenannten Quadratur-AmplitudenModulation (QAM) oder dem sogenannten Phase-Shift-Keying (PSK), betrifft daher die Modulation eines Sendesignal sowohl die Amplitude als auch den Winkel. Die Modulation des ausgehenden Sendesignals erfolgt hierbei nach einem festgelegten, im jeweiligen Sendestandard spezifizierten sogenannten Bildungsgesetz. Das heißt, dieses Bildungsgesetz gibt vor, wie die Modulation des Signals bei der Übertragung eines bestimmten Informationsinhalts, d.h. für eine bestimmte Symbolfolge, auszusehen hat. Im komplexen Basisband (d.h. in der I/Q-Ebene) lässt sich ein Sendesignal $\underline{s}(t)$ im Allgemeinen durch eine Überlagerung von Grundimpulsen $p(t)$ darstellen, die jeweils um $i \cdot T$ zeitverschoben und mit komplexen Faktoren $\underline{a}_i$ gewichtet, überlagert werden:

$$\underline{s}(t) = \sum_i \underline{a}_i\, p(t - iT)$$

Hierbei ist $i$ eine Laufvariable für das i-te Symbol und $T$ ist die Symboldauer, d.h. der Abstand zwischen zwei Symbolen. Dieses hier dargestellte Bildungsgesetz ist lediglich ein typisches Beispiel für ein Bildungsgesetz, was jedoch derzeit in vielen Mobilfunkstandards verwendet wird. Unter dem Begriff "Bildungsgesetz" sind im Sinne dieser Schrift folglich insbesondere das dargestellte Bildungsgesetz, aber auch andere ähnliche Bildungsgesetze zu verstehen.

Ein Problem bei der direkten Übernahme der Polarkoordinaten zur Erzeugung des winkel- und amplitudenmodulierten Signals tritt dann auf, wenn aufgrund der zu übermittelnden Informationen das Sendesignal gemäß dem Bildungsgesetz so auszusehen hat, dass der Sendekurvenzug in der komplexen I/Q-Ebene nahe am Ursprung vorbeiführt. Bei einer konstanten Bahngeschwindigkeit steigt dann die Winkelgeschwindigkeit, d.h. die Geschwindigkeit, mit der sich der Zeiger innerhalb der komplexen I/Q-Ebene dreht, betragsmäßig erheblich an, was das Spektrum des Momentanfrequenzsignals (= Winkelgeschwindigkeit) stark verbreitert. Zudem wird der Zeiger selbst zu diesem Punkt sehr kurz, d.h. die Amplitude wird sehr klein, was sich in der Hüllkurve des Sendesignals durch einen spitzen Einbruch bemerkbar macht. Hierdurch wird das Spektrum des Amplitudensignals in unerwünschter Weise verbreitert. Ein Extremfall liegt dann vor, wenn der Sendekurvenzug direkt durch den Ursprung verlaufen sollte. In diesem Fall fällt das Amplitudensignal bis auf 0 ab, was dazu führt, dass die Amplitudenmodulation, welche durch das Verhältnis der maximalen Amplitude zur minimalen Amplitude definiert ist, ins Unendliche steigt. Bezüglich des Winkels kommt es dabei zu einem Phasensprung. Ein solcher Phasensprung ist insbesondere ungünstig, wenn der Winkel des Zeigers unmittelbar dazu verwendet wird, um beispielsweise mittels einer Phasenregelschleife das winkelmodulierte Signal zu erzeugen. Ein Phasensprung könnte hier zu einem vorübergehenden Ausrasten der Phasenregelschleife führen.

Das Dokument US-A-5 805 640 offenbart ein Verfahren zur Erzeugung eines amplituden- und winkelmodulierten Sendesignals, bei dem das Sendesignal entgegen einem vorgegebenen Bildungsgesetz für die Modulation verfälscht wird, indem durch Addition von das Signal seitlich verschiebenden Impulsen Amplituden unter einem vorgegebenen Schwellwert konsequent eliminiert werden.

Es ist Aufgabe der vorliegenden Erfindung, ein Verfahren und eine entsprechende Sendeschaltung zu schaffen, welche eine direkte Umsetzung der Amplituden- und Winkelinformationen des Basisbandsignals in ein amplituden- und winkelmoduliertes Sendesignal bei effizienter, linearer Verstärkung erlaubt.

Diese Aufgabe wird durch ein Verfahren gemäß Patentanspruch 1 gelöst.

Dementsprechend wird hierbei das Sendesignal entgegen dem Bildungsgesetz, welches für den jeweiligen Übertragungsstandard vorgegeben ist, so verfälscht, dass sich die Amplitudenmodulation gegenüber dem unverfälschten Sendesignal vermindert und/oder das Spektrum des Sendesignals in mindestens einer seiner polaren Komponenten im komplexen Basisband gegenüber dem unverfälschten Sendesignal schmaler wird. Das heißt, das Signal wird dann, wenn beispielsweise die Amplitude unter einen Amplitudenminimalwert fallen oder der Betrag der Winkelgeschwindigkeit über einen Winkelgeschwindigkeitsmaximalwert steigen würde, so verfälscht, dass dem weiteren Abfall der Amplitude entgegengewirkt wird und die Amplitude oberhalb eines vorgegebenen Werts bleibt. Auf die gleiche Weise kann durch eine kurzzeitige Verfälschung eingegriffen werden, wenn die Winkelgeschwindigkeit zu hoch wird.

Ebenso kann das Signal verfälscht werden, wenn die Amplitude droht, über einen Maximalwert hinauszulaufen, d.h. um einen unerwünschten Überschwinger des Signals zu vermeiden. Der Hauptfall der Anwendung liegt jedoch in der Regel darin, ein zu nahes Vorbeilaufen des Sendekurvenzugs am Ursprung der I/Q-Ebene und die damit verbundenen, oben beschriebenen Einbrüche in der Hüllkurve des Sendesignals, etwaige Phasensprünge sowie die Verbreiterung des Spektrums der vom Sendesignal abgeleiteten Teilsignale, d.h. der Amplitudeninformation, des rein winkelmodulierten Signals oder der Momentanfrequenz, zu vermeiden.

Das Sendesignal braucht nicht ausnahmslos bei jedem Hüllkurveneinbruch oder -überschwinger verfälscht zu werden. Erfindungsgemäße Vorteile für die Erzeugung und/oder Verarbeitung des Sendesignals ergeben sich bereits auch dann, wenn hin und wieder eine im Allgemeinen unerwünscht kleine und/oder große Amplitude zugelassen wird. Besonders kleine und/oder besonders große Amplituden kommen dann zwar noch vor, sind jedoch seltener als im ursprünglichen Signal. Bei kleinen Amplituden braucht das Sendesignal insbesondere dann nicht verfälscht zu werden, wenn sich der Zeiger in der Nähe des Ursprungs der I/Q-Ebene nur sehr langsam bewegt.

Eine derartige Verfälschung ist beispielsweise möglich, indem zu bestimmten Zeitpunkten, nämlich dann, wenn z.B. der Sendekurvenzug in der komplexen I/Q-Ebene zu nah am Ursprung vorbeiläuft, Impulse auf das Sendesignal aufaddiert werden.

Hierbei reicht oft ein einzelner Impuls aus. Alternativ kann aber auch eine Kombination mehrerer beispielsweise sich zeitlich überlappender Impulse mit unterschiedlicher Lage in der I/Q-Ebene auf das Sendesignal addiert werden, um eine bessere Wirkung zu erzielen. Im Folgenden wird der Einfachheit halber aber nur von Impulsen bzw. einem Impuls gesprochen. Sofern nicht anders erwähnt, ist aber davon auszugehen, dass es sich hierbei auch um eine Impulskombination handeln kann.

Ein Impuls kann beispielsweise durch eine inverse Fouriertransformation der Quadratwurzel eines "Wunschleistungsdichtespektrums" gewonnen werden. Ein auf diese Weise erzeugter Impuls ist reellwertig und spiegelsymmetrisch mit einem Maximum auf der Zeitachse bei t=0.

Das Wunschleistungsdichtespektrum kann dabei das Sendeleistungsdichtespektrum sein. Wird außerdem darauf geachtet, dass die Impulse, die auf das Sendesignal zur Verfälschung aufaddiert werden, untereinander und zum Sendesignal unkorreliert sind, so bleibt das Sendeleistungsdichtespektrum in seiner Form erhalten.

Es ist aber auch möglich, ein Korrekturspektrum als Wunschleistungsdichtespektrum zu wählen, um das Sendeleitungsdichtespektrum gezielt etwas zu verändern und die Passgenauigkeit in eine vorgegebene spektrale Maske zu verbessern.

Insgesamt müssen die Impulse zum Verschmälern der Bandbreite in den polaren Koordinaten aber so klein und/oder so selten sein, dass die Modulationsgenauigkeit den Anforderungen des entsprechenden Funkstandards noch entspricht.

Um bei einem zu nahen Vorbeilaufen des unverfälschten Sendekurvenzugs am Ursprung oder sogar bei einem Durchlaufen durch den Ursprung die schnelle Phasenänderung und den Einbruch der Hüllkurve zu vermeiden, wird ein Zeitpunkt für den Impuls vorzugsweise so gewählt, dass ein Maximum des Impulses mit dem Minimum der Amplitude des zu verfälschenden Sendesignals zusammenfällt. Alternativ ist es möglich, für die zeitliche Lage eines Impulses den Zeitpunkt maximaler Winkelgeschwindigkeit des unverfälschten Sendesignals als Präferenz zu nehmen. In den meisten Fällen liegen die Zeitpunkte einer minimalen Amplitude und der maximalen Winkelgeschwindigkeit nahe zusammen .

Die Größe und/oder die Richtung, d.h. die Verteilung des Impulses auf I und Q, werden vorzugsweise so gewählt, dass zum Zeitpunkt eines Minimums der Amplitude des unverfälschten Sendesignals der zugehörige Zeiger in der I/Q-Ebene radial vom Ursprung des Koordinatensystems nach außen verschoben wird. Das heißt, es wird der Abstand zwischen dem Ursprung und der ursprünglichen, unverfälschten Zeigerbahn in radialer Richtung vergrößert und so der Amplitudeneinbruch verringert.

Vorzugsweise wird der Verlauf des Impulses im komplexen Basisband so gewählt, dass zumindest von dem Impuls auch ein Anteil in tangentialer Richtung bezüglich einer Bahn des zum unverfälschten Sendesignals gehörigen Zeigers, d.h. in tangentialer Richtung zum Sendekurvenzug, umfasst ist. Ein solcher Impuls, der nicht nur einen Anteil orthogonal zur Tangente an die Bahn des Zeigers aufweist, sondern auch einen Anteil tangential zur Bahn hat, dient dazu, um die Winkelgeschwindigkeit beim Vorbeilaufen des Zeigers am Ursprung zu verringern und somit insbesondere das Spektrum bezüglich der Momentanfrequenz zu verringern.

Bei derartigen Beinahe-0-Durchgängen oder 0-Durchgängen durch den I/Q-Ursprung reichen schon kleine Impulse aus, um die Bandbreiten sichtbar zu verschmälern und einen Phasensprung und damit ein Ausrasten einer Phasenregelschleife, beispielsweise einer über einen Sendeverstärker rückgekoppelten PLL (Phase-Locked-Loop), zu verhindern.

Auf der Empfängerseite haben solche zusätzlichen Impulse keine beachtlichen Auswirkungen, d.h. sie verfälschen die eigentliche Information nicht wesentlich, da die Zeitpunkte, an denen die Zusatzimpulse auf das Ursprungssignal addiert werden, gerade zwischen den idealen Abtastzeitpunkten liegen. Das heißt, sie liegen zwischen den Zeitpunkten größter Augenöffnung des Empfangssignals, an denen die eigentlichen Informationen in der Regel wiedergewonnen werden. Wie eingangs beschrieben sind die eigentlichen Informationen in der Reihenfolge der festgelegten Punkte in der I/Q-Ebene kodiert und die Sendekurvenzüge sind so gestaltet, dass sie die Punkte in der gewünschten Reihenfolge anfahren. Da bei einer Phasenumtastung die Punkte alle auf einer Kreisbahn um den Ursprung liegen, d.h. der Zeiger bei Erreichen eines Punktes im Wesentlichen seine maximale Länge hat, sind die Informationen über die betreffenden Punkte immer in den Bereichen der maximalen Amplitude des Sendesignals, d. h. den Zeitpunkten der größten Augenöffnung des Empfangssignals, enthalten.

Insbesondere bei einer Übertragung zu solchen Empfängern, die das Empfangssignal filtern und nur zum Zeitpunkt maximaler Augenöffnung abtasten, werden vorteilhafterweise die Zusatzimpulse so gestaltet, dass sie nach der Faltung mit einer Impulsantwort des Empfangsfilters die Augenöffnung zum Abtastzeitpunkt gar nicht oder nicht wesentlich verkleinern.

Wenn es darum geht, unerwünschte Überschwinger zu unterdrükken, so wird zum Zeitpunkt eines Maximums der Amplitude die Größe und/oder Richtung des Impulses im komplexen Basisband so gewählt, dass zum Zeitpunkt des Maximums der Amplitude des unverfälschten Sendesignals der zugehörige Zeiger im komplexen Basisband radial in Richtung des Ursprungs nach innen verschoben wird. Auf diese Weise wird dem Überschwinger entgegengewirkt. Das heißt, der Überschwinger wird in Richtung auf den Ursprung hin kompensiert. Um hier eine ausreichende Kompensation zu erzielen, sind in der Regel betragsmäßig höhere Impulse notwendig als bei einer "Korrektur" eines zu nah am Ursprung vorbeilaufenden Sendezugs.

Ferner wird die Aufgabe durch eine Sendeschaltung gemäß Patentanspruch 16 gelöst.

Hierbei handelt es sich vorzugsweise um Mittel zur Addition von Impulsen oder von Impulskombinationen zu bestimmten Zeitpunkten auf das Sendesignal.

Eine Möglichkeit zu entscheiden, wann ein Impuls bzw. eine Impulskombination in welcher Größe und in welcher Richtung zu welchem Zeitpunkt auf das unverfälschte Signal aufaddiert wird (d.h. um festzulegen, wann das Signal wie verfälscht wird) besteht darin, dass für bestimmte Symbolfolgen des unverfälschten Sendesignals bereits der Impuls bzw. die Impulskombination im Voraus bestimmt wird und entsprechende Daten zur Erzeugung des Impulses und/oder der Impulskombination in einem Speicher hinterlegt werden. In diesem Fall wird einfach, sobald die entsprechende Symbolfolge auftritt, der Impuls gemäß den Daten auf das unverfälschte Sendesignal aufaddiert.

Eine bevorzugte Alternative sieht vor, für solche Fälle bereits verfälschte Signale, d.h. verfälschte Sendekurvenzüge, in einem Speicher zu hinterlegen. Diese Sendekurvenzüge können beispielsweise schon werkseitig in einem Speicher des Geräts hinterlegt werden. Dieses Verfahren hat insbesondere dann Vorteile, wenn ohnehin die Umsetzung von einer Symbolfolge in das zugehörige Signal bzw. die IQ-Komponenten des Signals erfolgt, indem aus einer Tabelle die zugehörigen Sendekurvenzüge entnommen werden, wie dies bei vielen derzeit auf dem Markt befindlichen Geräten der Fall ist. In diesem Fall ist es lediglich erforderlich, dass nach einer Berechnung der Sendekurvenzüge nach dem vorgesehenen Bildungsgesetz der Sendekurvenzug hinsichtlich eventueller Problemstellen, beispielsweise eines zu engen Vorbeilaufens am Ursprung in der I/Q-Ebene analysiert wird und dann anstelle des unverfälschten Sendekurvenzugs ein gemäß der Erfindung verfälschter Sendekurvenzug, auf den beispielsweise bereits ein geeigneter Impuls aufaddiert wurde, hinterlegt wird.

Eine entsprechende Sendeschaltung muss in diesem Fall einen Speicher aufweisen, in dem entweder für die bestimmten Symbolfolgen des unverfälschten Sendesignals entsprechende Daten zur Erzeugung eines Impulses bzw. einer Impulskombination oder aber sogar direkt die Daten des bereits entsprechend verfälschten Signals, beispielsweise der verfälschte Sendekurvenzug, hinterlegt sind. Letztere Variante ermöglicht auch, das verfälschte Signal in den polaren Koordinaten Amplitude und Winkel oder in einer Kombination von kartesischen und polaren Koordinaten zu speichern, was für die Signalerzeugung bei mit EER verwandten Sendeschaltungen von Vorteil ist.

Mit einer geeigneten Logik kann im Übrigen bei einer Speicherung der Daten die Datenmenge unter Ausnutzung einer Symmetrieeigenschaft des Impulses oder der Impulskombination reduziert werden.

Bei einer alternativen Ausführungsform des Verfahrens wird dagegen erst während des Sendens in Abhängigkeit von den jeweils zu sendenden Daten entschieden, ob und in welcher Form ein Impuls bzw. eine Impulskombination zu dem Signal hinzuaddiert wird.

In diesem Fall kann der geeignete Impuls auch in seiner Form und Richtung jeweils erst unmittelbar vorher berechnet werden. Alternativ ist es möglich, dass verschiedene Impulse und Impulskombinationen bzw. entsprechende Daten zur Erzeugung dieser Impulse und Impulskombinationen in einem Speicher hinterlegt sind und die Sendeschaltung einfache Mittel aufweist, um in Abhängigkeit von den Sendedaten zu entscheiden, welche Art von Impuls bzw. Impulskombination verwendet wird und dementsprechend einen Impuls oder eine Impulskombination aus dem Speicher ausgewählt wird.

Da eine Addition von zwei Vektoren in kartesischen Koordinaten einfacher ist als in Polarkoordinaten und dementsprechend weniger Rechenaufwand erfordert, ist es vorteilhaft, wenn die Impulse zur Verfälschung des Signals in kartesischen Koordinaten, d.h. beispielsweise in den I/Q-Koordinaten, auf das unverfälschte Signal addiert werden und erst danach die Summe in Polarkoordinaten, d.h. in die Amplitude und den Winkel, umgerechnet wird. Dies ist insbesondere dann sinnvoll, wenn erst während der Sendezeit entschieden wird, welche Impulse auf das Sendesignal aufaddiert werden. In diesem Fall bietet es sich bei einer Abspeicherung von Sendekurvenzügen an, das ursprüngliche Signal in kartesischen Koordinaten, d.h. wie bisher in den IQ-Koordinaten, abzuspeichern.

Vorzugsweise sollten die Impulse so gewählt werden, dass durch die Verfälschungen der Mittelwert des Sendesignals insgesamt nicht wesentlich verschoben wird.

Bei einer Bestimmung der Verfälschung von bestimmten Sendekurvenzügen im Voraus kann dies dadurch eingerichtet werden, indem - bei einer unterstellten statistischen Verteilung der Daten - die Impulse so in die Sendekurvenzüge eingearbeitet werden, dass für die zu erwartenden Daten im zeitlichen Mittel die Mittelwertverschiebung von I und Q nahezu 0 oder zumindest sehr gering ist.

Sofern erst während des Sendens Impulse auf das unverfälschte Signal addiert werden, kann dynamisch in Abhängigkeit von den zu sendenden Daten sowie der Vorgeschichte, d.h. in Abhängigkeit von den bereits zuvor addierten Impulsen, entschieden werden, welche Richtung und Größe ein erneuter Impuls aufweist, wobei dieser neu zu addierende Impuls dann nicht nur günstig bezüglich der Verfälschung des Signals gewählt wird, sondern auch so, dass durch die Summe aller aufaddierten Impulse der Mittelwert in der komplexen I/Q-Ebene nicht wesentlich verschoben wird. Hierzu wird vorzugsweise eine Information über die bereits addierten Impulse in geeigneter Form gespeichert, um die bereits erfolgten Verfälschungen berücksichtigen zu können.

Sofern die Verfälschung bei der Erzeugung von Sendesignalen in Multiplex-Systemen angewendet wird, wird vorzugsweise auch darauf geachtet, dass andere Übertragungen möglichst wenig gestört werden.

Beim sogenannten Frequenzmultiplexverfahren ist dies bei solchen Impulsen automatisch erfüllt, deren Spektrum nicht nennenswert in die Nachbarkanäle hineinragt.

Beim sogenannten Code-Multiplexverfahren werden die Impulse vorteilhafterweise so gewählt, dass sie im sogenannten "Coderaum" orthogonal zu den Codes sind, die allgemein oder in der jeweiligen Situation nicht gestört werden sollen. Orthogonal zu den für die eigene und für fremde Übertragungen verwendeten Codes sind beispielsweise ungenutzte Codes des gleichen Coderaums. Da die Orthogonalität aber von der zeitlichen Lage des jeweiligen Impulses abhängen kann, ist es vorteilhaft, die zeitliche Lage des Impulses auch im Hinblick auf die Störungen in den gegebenenfalls betroffenen anderen Übertragungen zu wählen und nicht nur die Optimierung des Sendesignals für die eigene Übertragung zu beachten.

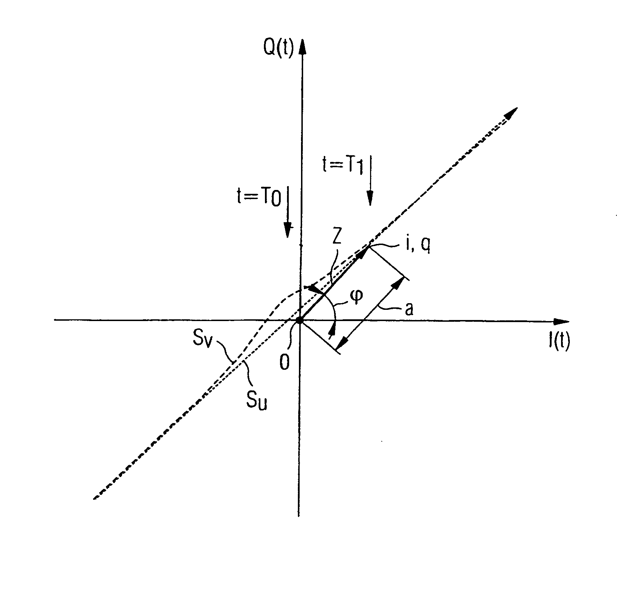

Die Erfindung wird im Folgenden unter Hinweis auf die beigefügte Figur anhand von Ausführungsbeispielen näher erläutert. Es wird ausdrücklich darauf hingewiesen, dass die einzelnen Merkmale nicht nur in den beschriebenen Kombinationen, sondern auch einzeln oder in anderen Kombinationen erfindungswesentlich sein können. Insbesondere können alle nur verfahrensmäßig beschriebenen Merkmale auch bezüglich einer entsprechenden Schaltung erfindungswesentlich sein und umgekehrt. Die einzige Figur zeigt einen Sendekurvenzug eines unverfälschten Signals in der komplexen I/Q-Ebene, welche nahe am Ursprung vorbeiläuft, und den Sendekurvenzug dieses Signals nach einer Verfälschung durch einen zum Zeitpunkt der geringsten Amplitude aufaddierten Impuls.

Bei dem dargestellten Beispiel läuft das ursprüngliche Sendesignal bzw. der zugehörige Sendekurvenzug $S_u$ in der komplexen I/Q-Ebene vom dritten durch den zweiten in den ersten Quadranten. Entlang seiner ursprünglichen Bahn kommt der unverfälschte Sendekurvenzug $S_u$ dem Ursprung O der I/Q-Ebene sehr nahe. Dieser unverfälschte Sendekurvenzug $S_u$ ist in der Figur gepunktet eingezeichnet.

Zusätzlich eingezeichnet ist zur Verdeutlichung der Zeiger Z zu einem bestimmten Zeitpunkt $T_1$.

Dieser Zeiger ist durch die karthesischen Koordinaten i und q in der I/Q-Ebene definiert. Die Länge a des Zeigers Z bestimmt zu diesem Zeitpunkt $T_1$ die Amplitude des Signals, der Winkel φ zwischen dem Zeiger Z und der I-Achse entspricht dem Winkel des Sendesignals zum Zeitpunkt $T_1$.

Aus dieser Figur ist leicht ersichtlich, dass bei einer konstanten Bahngeschwindigkeit entlang des Sendekurvenzugs $S_u$ die Winkelgeschwindigkeit, mit der der Zeiger Z in der I/Q-Ebene gedreht wird, betragsmäßig stark zunimmt, wenn die Spitze des Zeigers Z auf dem Sendekurvenzug $S_u$ am Ursprung vorbeiläuft. Gleichzeitig nimmt die Länge a des Zeigers Z, d.h. die Amplitude, stark ab, bis sie zum Zeitpunkt $T_0$ des geringsten Abstands des Sendekurvenzugs $S_u$ vom Ursprung O ihr Minimum erreicht. Bei konstanter Bahngeschwindigkeit ist dies auch der Zeitpunkt der geringsten Winkelgeschwindigkeit. Im amplituden- und winkelmodulierten Sendesignal ist dieser Zeitpunkt $T_0$ durch eine sehr schnelle Phasenänderung und einen spitzen Einbruch in der Hüllkurve charakterisiert.

Um sowohl den Einbruch in der Hüllkurve zu vermeiden, als auch die Winkelgeschwindigkeit in diesem Bereich zu reduzieren, wird genau zu diesem Zeitpunkt $T_0$ ein kleiner Impuls aufaddiert, welcher von der Richtung her radial vom Ursprung O aus in Richtung des Sendekurvenzugs $S_u$ nach außen zeigt. Dadurch entsteht insgesamt der gestrichelt dargestellte, verfälschte Sendekurvenzug $S_V$, der den Ursprung O der I/Q-Ebene in einem größeren Abstand umgeht. Dies führt zu der gewünschten Verminderung des Hüllkurveneinbruchs sowie zu der gewünschten Verringerung der betragsmäßig maximalen Winkelgeschwindigkeit.

Um die Winkelgeschwindigkeit beim Vorbeilaufen des Zeigers Z am Ursprung O noch stärker zu reduzieren, kann es außerdem vorteilhaft sein, nicht nur einen Impuls mit einem Anteil orthogonal zum Sendekurvenzug zu addieren, sondern auch einen tangentialen Anteil vorzusehen, insbesondere derart, dass durch den Impuls die Bewegung des Zeigers Z in tangentialer Richtung zum Zeitpunkt größter Annäherung an den Ursprung und/oder zum Zeitpunkt betragsmäßig maximaler Winkelgeschwindigkeit verlangsamt wird.

Das heißt, es können auch Impulse mit einer Auslenkung in zwei Richtungen addiert werden. Ein Beispiel hierfür ist ein Impuls, welcher nach der Formel

$$I(t) + jQ(t) = 1 - \exp[j\pi(1 + \sin(\pi t/(2T)))] \quad \textit{für } -T \le t \le T$$

beschrieben wird. Dabei ist T das halbe Zeitintervall, in dem der Impuls addiert wird, und $j^2 = -1$. Bei dem durch diese die Formel beschriebenen Impuls handelt es sich um eine rechts vom Ursprung liegende Kreisbahn, die im mathematisch positiven Drehsinn durchlaufen wird. Ein solcher Impuls eignet sich insbesondere für einen unverfälschten Sendekurvenzug, der entlang der Q-Achse durch den Ursprung O herunterläuft (nicht dargestellt). Durch geeignete Wahl der Parameter, wie die Größe des Kreises und die Geschwindigkeit des Durchlaufens, kann die Winkelgeschwindigkeit des unverfälschten Sendekurvenzugs durch Addition des kreisförmigen Impulses noch wirksamer gesenkt werden als bei einer Auslenkung in nur einer Richtung senkrecht zum unverfälschten Sendekurvenzug, d.h. in diesem Beispiel durch einen Impuls mit nur einer Inphasekomponente. Dieses Beispiel soll nur aufzeigen, wie bei einem Impuls mit einer Auslenkung in zwei Richtungen die beiden Richtungen prinzipiell zusammenwirken können. Das Beispiel ist jedoch an kein Sendeleistungsdichtespektrum angepasst. Es soll außerdem auch nicht einschränkend auf eine bestimmte Form oder einen bestimmten zeitlichen Verlauf zu sehen sein.

In der Praxis relevante Impulse sind vorzugsweise so gewählt, dass sie möglichst kleine Sprünge in der Zeigerbahn und deren zeitlichen Ableitungen verursachen. Der soeben genannte kreisförmige Impuls ist beispielsweise so konstruiert. Ebenso entspricht aber auch ein durch eine inverse Fouriertransformation gewonnener Impuls im Allgemeinen dieser Vorgabe.

Die Impulse sind vorzugsweise jeweils so ausgewählt, dass das Leistungsdichtespektrum das Sendeleistungsdichtespektrum möglichst nicht verändert, zumindest nicht verbreitert. Dies ist möglich, indem die Impulse so ausgewählt werden, dass das Leistungsdichtespektrum dem Sendeleistungsdichtespektrum entspricht und Impulse untereinander und zum Sendesignal unkorreliert sind.

Durch die erfindungsgemäße, zielgerichtete Verfälschung der Modulation gegenüber dem vorgegebenen Bildungsgesetz wird die Bandbreite der Signale für die Momentanfrequenz und die Amplitude und somit die Anforderung an eine Sendeschaltung reduziert und damit die Gesamtperformance der Sendeschaltung verbessert.

Bei Modulationsarten, welche ein hohes peak-to-minimum ratio, d.h. Verhältnis von maximaler zu minimaler Amplitude, und insbesondere auch einen großen Power-Control-Level-Bereich aufweisen, kann der gesamte Dynamikumfang 120 dB überschreiten. Die Isolation der Endstufe kann dann unzureichend sein, so dass es zu einem unzulässigen Carrier Feedthrough, d. h. zu einem ungewollten Durchlassen des zu unterdrückenden Trägers, kommen kann. Die Reduzierung der Anforderungen an den Dynamikbereich kann bezüglich dieser Probleme zusätzlichen Nutzen bringen. Die Erfindung eignet sich besonders zum Einsatz in Sendeschaltungen im Mobilfunkbereich. Sie ist aber nicht auf diesen Bereich beschränkt.

Ferner kann aus dem Bildungsgesetz für eine lineare Modulation durch eine Verfälschung der Modulation gemäß der Lehre dieser Erfindung auch ein neue Vorschrift für eine Modulation bzw. Zuordnung von Symbolen zu einer Zeigerbahn erstellt werden.

Bezugszeichenliste

| | | |
|---|---|---|
| Z | | Zeiger |
| O | | Ursprung der komplexen I/Q-Ebene |
| $\varphi$ | | Winkel des Zeigers zur I-Achse |
| a | | Länge des Zeigers |
| i | | I-Komponente des Zeigers |
| q | | Q-Komponente des Zeigers |
| t | | Zeitvariable |
| $T_1$ | | Zeitpunkt |
| $T_0$ | | Zeitpunkt |
| $S_v$ | | verfälschter Sendekurvenzug |
| $S_u$ | | unverfälschter Sendekurvenzug |

**Patentansprüche**

1. Verfahren zur Erzeugung eines amplituden- und winkelmodulierten Sendesignals ($S_v$), bei dem das Sendesignal ($S_v$) entgegen einem vorgegebenen Bildungsgesetz für die Modulation so verfälscht wird, dass sich die Amplitudenmodulation gegenüber dem unverfälschten Sendesignal ($S_u$) vermindert und/oder das Spektrum des Sendesignals ($S_v$) in mindestens einer seiner polaren Komponenten im komplexen Basisband gegenüber dem unverfälschten Sendesignal ($S_u$) schmaler wird, **dadurch gekennzeichnet, dass** für das verfälschte Sendesignal ($S_v$) ein winkelmoduliertes Signal und ein Amplitudensignal erzeugt werden und das winkelmodulierte Signal an einen ersten Eingang eines Sendeverstärkers angelegt wird und das Amplitudensignal an zumindest einen zweiten Eingang des Sendeverstärkers angelegt wird und die Amplitude dabei im Sendeverstärker auf das winkelmodulierte Signal aufmoduliert wird.

2. Verfahren nach Anspruch 1, **dadurch gekennzeichnet, dass** das winkelmodulierte Signal und Amplitudensignal für das verfälschte Sendesignal ($S_v$) unter Verwendung der Polarkoordinaten erzeugt werden.

3. Verfahren nach Anspruch 1 oder 2, **dadurch gekennzeichnet, dass** zur Verfälschung des Sendesignals zu bestimmten Zeitpunkten Impulse auf das Sendesignal addiert werden.

4. Verfahren nach Anspruch 3, **dadurch gekennzeichnet, dass** zu einem Zeitpunkt eine Kombination mehrerer Impulse auf das Sendesignal ($S_u$) addiert wird.

5. Verfahren nach Anspruch 3 oder 4, **dadurch gekennzeichnet, dass** ein Zeitpunkt für einen Impuls oder eine Impulskombination so gewählt wird, dass ein Maximum des Impulses oder der Impulskombination mit einem Maximum oder einem Minimum der Amplitude des Sendesignals ($S_u$) zusammenfällt.

6. Verfahren nach einem der Ansprüche 3 bis 5, **dadurch gekennzeichnet, dass** ein Zeitpunkt für einen Impuls oder eine Impulskombination so gewählt werden, dass ein Maximum des Impulses oder der Impulskombination auf einen Zeitpunkt der betragsmäßig maximalen Winkelgeschwindigkeit der Bahn ($S_u$) des Zeigers (Z) fällt, der das unverfälschte Sendesignal im komplexen Basisband repräsentiert.

7. Verfahren nach einem der Ansprüche 3 bis 6, **dadurch gekennzeichnet, dass** eine Größe und/ oder eine Richtung des Impulses oder der Impulskombination im komplexen Basisband so gewählt wird, dass zum Zeitpunkt ($T_0$) eines Minimums der Amplitude des unverfälschten Sendesignals der zugehörige Zeiger (Z) im komplexen Basisband radial vom Ursprung des Basisbandkoordinatensystems nach außen verschoben wird.

8. Verfahren nach einem der Ansprüche 3 bis 6, **dadurch gekennzeichnet, dass** eine Größe und/ oder eine Richtung des Impulses oder der Impulskombination im komplexen Basisband so gewählt wird, dass zum Zeitpunkt eines Maximums der Amplitude des unverfälschten Sendesignals der zugehörige Zeiger (Z) im komplexen Basisband radial in Richtung des Ursprungs des Basisbandkoordinatensystems nach innen verschoben wird.

9. Verfahren nach einem der Ansprüche 3 bis 8, **dadurch gekennzeichnet, dass** die Richtung des Impulses oder der Impulskombination im komplexen Basisband so gewählt wird, dass zumindest ein Anteil in tangentialer Richtung bezüglich einer Bahn des zum unverfälschten Sendesignal gehörigen Zeigers im komplexen Basisband umfasst ist.

10. Verfahren nach einem der Ansprüche 1 bis 9, **dadurch gekennzeichnet, dass** für bestimmte Symbolfolgen des unverfälschten Sendesignals die Verfälschung des Sendesignals im Voraus bestimmt wird und Daten zur Erzeugung der Verfälschung oder Daten des bereits verfälschten Signals in einem Speicher hinterlegt werden.

11. Verfahren nach Anspruch 10, **dadurch gekennzeichnet, dass** bei der Speicherung der Daten die Datenmenge unter Ausnutzung einer Symmetrieeigenschaft eines zur Verfälschung verwendeten Impulses oder der Kombination von Impulsen reduziert wird.

12. Verfahren nach einem der Ansprüche 1 bis 11, **dadurch gekennzeichnet, dass** während des Sendens in Abhängigkeit von den zu sendenden Daten ermittelt wird ob und in welcher Form ein Impuls oder eine Impulskombination zu dem Signal hinzuaddiert wird.

13. Verfahren nach einem der Ansprüche 3 bis 12, **dadurch gekennzeichnet, dass** die Impulse und/ oder die Impulskombinationen in kartesischen Koordinaten (i,q) auf das unverfälschte Sendesignal addiert werden und dann eine Umwandlung der Koordinaten des verfälschten Sendesignals in Polarkoordinaten (a, $\phi$) erfolgt.

14. Verfahren nach einem der Ansprüche 3 bis 13, **dadurch gekennzeichnet, dass** die Impulse und/ oder Impulskombinationen so gewählt werden, dass sie den zeitlichen Mittelwert des Sendesignals gegenüber dem unverfälschten Sendesignal nicht verschieben.

15. Verfahren nach einem der Ansprüche 3 bis 14, **dadurch gekennzeichnet, dass** ein Impuls oder eine Impulskombination unter Verwendung einer inversen Fouriertransformation der Quadratwurzel eines gewünschten Leistungsdichtespektrums ermittelt wird.

16. Verfahren nach einem der Ansprüche 3 bis 15, **dadurch gekennzeichnet, dass** ein Impuls oder eine Impulskombination bei einer Übertragung im Codemultiplex unter Verwendung eines ungenutzten Codes ermittelt wird.

17. Sendeschaltung zur Erzeugung eines amplituden- und winkelmodulierten Sendesignals ($S_v$) mit Mitteln zur Erzeugung des Sendesignals aus einer Folge von Sendesymbolen, welche eine zu sendende Information enthalten, wobei die Mittel zur Erzeugung des Sendesignals Mittel umfassen, um das Sendesignal entgegen einem vorgegebenen Bildungsgesetz für die Modulation so zu verfälschen, dass sich die Amplitudenmodulation gegenüber dem unverfälschten Sendesignal ($S_u$) vermindert und/oder das Spektrum des Sendesignals in mindestens einer seiner polaren Komponenten im komplexen Basisband gegenüber dem unverfälschten Sendesignal schmaler wird, **dadurch gekennzeichnet, dass** in der Sendeschaltung für das verfälschte Sendesignal ein winkelmoduliertes Signal und ein Amplitudensignal erzeugt werden und das winkelmodulierte Signal an einen ersten Eingang eines Sendeverstärkers angelegt wird und das Amplitudensignal an zumindest einen zweiten Eingang des Sendeverstärkers angelegt wird und die Amplitude dabei im Sendeverstärker auf das winkelmodulierte Signal aufmoduliert wird.

**18.** Sendeschaltung nach Anspruch 17, **dadurch gekennzeichnet, dass** das winkelmodulierte Signal und Amplitudensignal für das verfälschte Sendesignal ($S_v$) unter Verwendung der Polarkoordinaten erzeugt werden.

**19.** Sendeschaltung nach Anspruch 17 oder 18, **gekennzeichnet durch** Mittel zur Addition jeweils eines Impulses oder einer Kombination von Impulsen zu bestimmten Zeitpunkten auf das Sendesignal zur Verfälschung des Sendesignals.

**20.** Sendeschaltung nach Anspruch 17, 18 oder 19, **gekennzeichnet durch** eine Entscheidungseinrichtung, die während des Sendens in Abhängigkeit von den zu sendenden Daten bestimmt, ob ein Impuls oder eine Impulskombination zu dem Signal hinzuaddiert wird.

**21.** Sendeschaltung nach einem der Ansprüche 17 bis 20, **gekennzeichnet durch** Mittel zur Bestimmung der zeitlichen Lage eines auszugebenden Impulses oder einer Impulskombination, um eine gewünschte Verfälschung zu erreichen.

**22.** Sendeschaltung nach einem der Ansprüche 17 bis 21, **gekennzeichnet durch** Mittel zur Bestimmung der Größe und/oder Richtung eines auszugebenden Impulses oder einer Impulskombination im komplexen Basisband, um eine gewünschte Verfälschung zu erreichen.

**23.** Sendeschaltung nach einem der Ansprüche 17 bis 22, **gekennzeichnet durch** einen Speicher, in welchem für bestimmte Symbolfolgen des unverfälschten Sendesignals Daten zur Erzeugung einer gewünschten Verfälschung des Sendesignals oder Daten des bereits entsprechend verfälschten Signals hinterlegt sind.

**24.** Sendeschaltung nach Anspruch 23, **gekennzeichnet durch** eine Logik, welche bei einer Speicherung der Daten die Datenmenge unter Ausnutzung einer Symmetrieeigenschaft eines zur Verfälschung verwendeten Impulses oder der Impulskombination reduziert.

**25.** Kommunikationsendgerät mit einer Sendeschaltung gemäß einem der Ansprüche 17 bis 24.

**Claims**

**1.** Method for generating an amplitude- and angle-modulated transmission signal ($S_v$) wherein said transmission signal ($S_v$) is falsified, contrary to a specified formation law for the modulation, in such a way that the amplitude modulation will be reduced compared to the non-falsified transmission signal ($S_u$) and/or the spectrum of the transmission signal ($S_v$) will become narrower in at least one of its polar components in the complex baseband compared to the non-falsified transmission signal ($S_u$), **characterized in that** an angle-modulated signal and an amplitude signal are generated for the falsified transmission signal ($S_v$) and the angle-modulated signal is applied to a first input of a transmission amplifier and the amplitude signal is applied to at least one second input of the transmission amplifier, with the amplitude being modulated in the transmission amplifier onto the angle-modulated signal.

**2.** Method according to claim 1 **characterised in that** the angle-modulated signal and amplitude signal for the falsified transmission signal ($S_v$) are generated using the polar coordinates.

**3.** Method according to claim 1 or 2 **characterised in that** for falsifying the transmission signal, pulses are added to the transmission signal at specific instants.

**4.** Method according to claim 3 **characterised in that** a combination of several pulses is added to the transmission signal ($S_u$) at an instant.

**5.** Method according to claim 3 or 4 **characterised in that** an instant for a pulse or combination of pulses is selected such that a maximum of the pulse or combination of pulses coincides with a maximum or minimum of the amplitude of the transmission signal ($S_u$).

**6.** Method according to one of claims 3 to 5 **characterized in that** an instant for a pulse or combination of pulses is selected such that a maximum of the pulse or combination of pulses occurs at an instant of the angular velocity that is maximum in amount of the path ($S_u$) of the pointer (Z) representing the non-falsified transmission signal in the complex baseband.

**7.** Method according to one of claims 3 to 6 **characterized in that** a magnitude and/or direction of the pulse or combination of pulses in the complex baseband is selected such that at the instant ($T_0$) of a minimum of the non-falsified transmission signal's amplitude the associated pointer (Z) in the complex baseband will be radially displaced outward from the origin of the baseband coordinate system.

**8.** Method according to one of claims 3 to 6

**characterized in that** a magnitude and/or direction of the pulse or combination of pulses in the complex baseband is selected such that at an instant of the maximum of the amplitude of the non-falsified transmission signal the associated pointer (Z) in the complex baseband will be radially displaced inward toward the origin of the baseband coordinate system.

9. Method according to one of claims 3 to 8 **characterised in that** the direction of the pulse or combination of pulses in the complex baseband is selected such that at least a portion tangentially oriented in terms of a path of the pointer belonging to the non-falsified transmission signal is included in the complex baseband.

10. Method according to one of claims 1 to 9 **characterised in that** for specific symbol sequences of the non-falsified transmission signal, falsifying of the transmission signal is determined in advance and data for generating the falsification or data of the signal already falsified is stored in a storage medium.

11. Method according to claim 10 **characterised in that** when the data is stored the volume of said data is reduced by exploiting a symmetry property of a pulse or combination of pulses used for falsifying.

12. Method according to one of claims 1 to 11 **characterised in that** it is determined, as a function of the data requiring to be sent, during transmission whether and in what form a pulse or combination of pulses will be added to the signal.

13. Method according to one of claims 3 to 12 **characterised in that** the pulses and/or combinations of pulses are added in Cartesian coordinates (i,q) to the non-falsified transmission signal and conversion of the coordinates of the falsified transmission signal into polar coordinates $(a, \varphi)$ then takes place.

14. Method according to one of claims 3 to 13 **Characterised in that** the pulses and/or combinations of pulses are selected such that they will not shift the transmission signal's mean value averaged over time compared to the non-falsified transmission signal.

15. Method according to one of claims 3 to 14 **characterised in that** a pulse or combination of pulses can be determined using an inverse Fourier transformation of the square root of a desired power density spectrum.

16. Method according to one of claims 3 to 15

**characterised in that** a pulse or combination of pulses is determined in the case of a transmission based on the multiplexing technique employing an unused code.

17. Transmission circuit for generating an amplitude- and angle-modulated transmission signal $(S_v)$ having means for generating the transmission signal from a sequence of transmission symbols containing an item of information requiring to be transmitted, wherein said means for generating said transmission signal includes means for falsifying the transmission signal contrary to a specified formation law for the modulation in such a way that the amplitude modulation will be reduced compared to the non-falsified transmission signal $(S_u)$ and/or the spectrum of the transmission signal in at least one of its polar components in the complex baseband will become narrower compared to the non-falsified transmission signal **characterized in that** an angle-modulated signal and an amplitude signal are generated in the transmission circuit for the falsified transmission signal and the angle-modulated signal is applied to a first input of a transmission amplifier and the amplitude signal is applied to at least one second input of the transmission amplifier, with the amplitude being modulated in the transmission amplifier onto the angle-modulated signal.

18. Transmission circuit according to claim 17 **characterised in that** the angle-modulated signal and amplitude signal for the falsified transmission signal $(S_v)$ are generated using the polar coordinates.

19. Transmission circuit according to claim 17 or 18 **characterised by** means for at specific instants adding in each case a pulse or combination of pulses to the transmission signal for falsifying the transmission signal.

20. Transmission circuit according to claim 17, 18 or 19 **characterised by** a decision device which determines during transmission as a function of the data requiring to be transmitted whether a pulse or combination of pulses will be added to the signal.

21. Transmission circuit according to one of claims 17 to 20 **characterised by** means for determining the time position of a pulse or combination of pulses requiring to be fed out for achieving a desired falsification.

22. Transmission circuit according to one of claims 17 to 21 **characterised by** means for determining the magnitude and/or direction of a pulse requiring to be fed out or a combination of such pulses in the complex baseband for achieving a desired falsification.

23. Transmission circuit according to one of claims 17 to 22
**characterised by** a storage medium in which data for generating a desired falsification of the transmission signal or data of the signal already falsified is stored for specific symbol sequences of the non-falsified transmission signal.

24. Transmission circuit according to claim 23
**characterised by** logic means which, when the data is stored, will reduce the data volume of said data by exploiting a symmetry property of a pulse or combination of pulses used for falsifying.

25. Communication terminal having a transmission circuit according to one of claims 17 to 24.

## Revendications

1. Procédé pour générer un signal d'émission ($S_v$) modulé en amplitude et en angle, dans lequel le signal d'émission ($S_v$) est altéré contrairement à une loi de formation prédéfinie pour la modulation de telle sorte que la modulation en amplitude se réduit par rapport au signal d'émission ($S_u$) non altéré et/ou le spectre du signal d'émission ($S_v$) devient plus étroit dans au moins l'un de ses composants polaires dans la bande de base complexe par rapport au signal d'émission ($S_u$) non altéré,
**caractérisé en ce que**, pour le signal d'émission ($S_v$) altéré, un signal modulé en angle et un signal d'amplitude sont générés et le signal modulé en angle est appliqué sur une première entrée d'un amplificateur d'émission et le signal d'amplitude est appliqué sur au moins une seconde entrée de l'amplificateur d'émission et l'amplitude est modulée alors dans l'amplificateur d'émission sur le signal modulé en angle.

2. Procédé selon la revendication 1, **caractérisé en ce que** le signal modulé en angle et le signal d'amplitude sont générés pour le signal d'émission ($S_v$) altéré en utilisant les coordonnées polaires.

3. Procédé selon la revendication 1 ou 2, **caractérisé en ce que**, pour l'altération du signal d'émission, des impulsions sont ajoutées à certains moments au signal d'émission.

4. Procédé selon la revendication 3, **caractérisé en ce que**, à un moment, une combinaison de plusieurs impulsions est ajoutée au signal d'émission ($S_u$).

5. Procédé selon la revendication 3 ou 4, **caractérisé en ce qu'**un moment pour une impulsion ou une combinaison d'impulsions est choisi de telle sorte qu'un maximum de l'impulsion ou de la combinaison d'impulsions coïncide avec un maximum ou un minimum de l'amplitude du signal d'émission ($S_u$).

6. Procédé selon l'une quelconque des revendications 3 à 5, **caractérisé en ce qu'**un moment pour une impulsion ou une combinaison d'impulsions est choisi de telle sorte qu'un maximum de l'impulsion ou de la combinaison d'impulsions coïncide avec un moment de la vitesse angulaire maximale au niveau de la valeur de la trajectoire ($S_u$) de l'aiguille ($Z$), qui représente le signal d'émission non altéré dans la bande de base complexe.

7. Procédé selon l'une quelconque des revendications 3 à 6, **caractérisé en ce qu'**une grandeur et/ou une direction de l'impulsion ou de la combinaison d'impulsions est choisie dans la bande de base complexe de telle sorte que, au moment ($T_0$) d'un minimum de l'amplitude du signal d'émission non altéré, l'aiguille correspondante ($Z$) est déplacée dans la bande de base complexe radialement depuis l'origine du système de coordonnées de la bande de base vers l'extérieur.

8. Procédé selon l'une quelconque des revendications 3 à 6, **caractérisé en ce qu'**une grandeur et/ou une direction de l'impulsion ou de la combinaison d'impulsions est choisie dans la bande de base complexe de telle sorte que, au moment d'un maximum de l'amplitude du signal d'émission non altéré, l'aiguille ($Z$) correspondante est déplacée dans la bande de base complexe radialement en direction de l'origine du système de coordonnées de la bande de base vers l'intérieur.

9. Procédé selon l'une quelconque des revendications 3 à 8, **caractérisé en ce que** la direction de l'impulsion ou de la combinaison d'impulsions est choisie dans la bande de base complexe de telle sorte qu'au moins une partie est incluse dans la direction tangentielle par rapport à une trajectoire de l'aiguille spécifique au signal d'émission non altéré dans la bande de base complexe.

10. Procédé selon l'une quelconque des revendications 1 à 9, **caractérisé en ce que**, pour certaines séquences de symboles du signal d'émission non altéré, l'altération du signal d'émission est déterminée à l'avance et des données pour générer l'altération ou des données du signal déjà altéré sont déposées dans une mémoire.

11. Procédé selon la revendication 10, **caractérisé en ce que**, lors du stockage des données, la quantité de données est réduite en utilisant une propriété de symétrie d'une impulsion utilisée pour l'altération ou de la combinaison d'impulsions.

12. Procédé selon l'une quelconque des revendications 1 à 11, **caractérisé en ce que**, pendant l'émission, on détermine en fonction des données à envoyer et si et sous quelle forme une impulsion ou une combinaison d'impulsions est ajoutée au signal.

13. Procédé selon l'une quelconque des revendications 3 à 12, **caractérisé en ce que** les impulsions et/ou les combinaisons d'impulsions sont ajoutées dans des coordonnées cartésiennes (i, q) au signal d'émission non altéré et une transformation des coordonnées du signal d'émission altéré en coordonnées polaires (a, φ) intervient alors.

14. Procédé selon l'une quelconque des revendications 3 à 13, **caractérisé en ce que** les impulsions et/ou combinaisons d'impulsions sont choisies de telle sorte qu'elles ne dépassent pas la valeur moyenne dans le temps du signal d'émission par rapport au signal d'émission non altéré.

15. Procédé selon l'une quelconque des revendications 3 à 14, **caractérisé en ce qu'**une impulsion ou une combinaison d'impulsions est déterminée en utilisant une transformation de Fourier inverse de la racine carrée d'un spectre de densité de puissance souhaité.

16. Procédé selon l'une quelconque des revendications 3 à 15, **caractérisé en ce qu'**une impulsion ou une combinaison d'impulsions est déterminée lors d'une transmission dans le multiplexage par répartition en code en utilisant un code non utilisé.

17. Circuit d'émission pour générer un signal ($S_v$) modulé en amplitude et en angle avec des moyens pour générer le signal d'émission à partir d'une séquence de symboles d'émission, qui contiennent une information à envoyer, les moyens pour générer le signal d'émission comprenant des moyens pour altérer le signal d'émission contrairement à une loi de formation prédéfinie pour la modulation de telle sorte que la modulation en amplitude est réduite par rapport au signal d'émission ($S_u$) non altéré et/ou le spectre du signal d'émission devient plus étroit dans au moins l'un de ses composants polaires dans la bande de base complexe par rapport au signal d'émission non altéré, **caractérisé en ce que**, dans le circuit d'émission pour le signal d'émission altéré, un signal modulé en angle et un signal d'amplitude sont générés et le signal modulé en angle est appliqué sur une première entrée d'un amplificateur d'émission et le signal d'amplitude est appliqué sur au moins une seconde entrée de l'amplificateur d'émission et l'amplitude est modulée alors dans l'amplificateur d'émission sur le signal modulé en angle.

18. Circuit d'émission selon la revendication 17, **caractérisé en ce que** le signal modulé en angle et le signal d'amplitude sont générés pour le signal d'émission ($S_v$) altéré en utilisant les coordonnées polaires.

19. Circuit d'émission selon la revendication 17 ou 18, **caractérisé par** des moyens pour l'addition de respectivement une impulsion ou une combinaison d'impulsions à certains moments au signal d'émission pour l'altération du signal d'émission.

20. Circuit d'émission selon la revendication 17, 18 ou 19, **caractérisé par** un dispositif de décision, qui détermine pendant l'émission en fonction des données à envoyer si une impulsion ou une combinaison d'impulsions est ajoutée au signal.

21. Circuit d'émission selon l'une quelconque des revendications 17 à 20, **caractérisé par** des moyens pour déterminer la position dans le temps d'une impulsion à envoyer ou d'une combinaison d'impulsions pour obtenir une altération souhaitée.

22. Circuit d'émission selon l'une quelconque des revendications 17 à 21, **caractérisé par** des moyens pour déterminer la grandeur et/ou la direction d'une impulsion à envoyer ou d'une combinaison d'impulsions dans la bande de base complexe pour obtenir une altération souhaitée.

23. Circuit d'émission selon l'une quelconque des revendications 17 à 22, **caractérisé par** une mémoire, dans laquelle, pour certaines séquences de symboles du signal d'émission non altéré, des données pour générer une altération souhaitée du signal d'émission ou des données du signal déjà altéré en conséquence sont déposées.

24. Circuit d'émission selon la revendication 23, **caractérisé par** une logique, qui réduit lors d'un stockage des données la quantité de données en utilisant une propriété de symétrie d'une impulsion utilisée pour l'altération ou de la combinaison d'impulsions.

25. Terminal de communication avec un circuit d'émission selon l'une quelconque des revendications 17 à 24.